Europäisches Patentamt

(19) European Patent Office

Office européen des brevets

(11) Publication number: **0 206 816 B1**

# EUROPEAN PATENT SPECIFICATION

(12)

(45) Date of publication of patent specification: **06.05.92**  (51) Int. Cl.⁵: **H03L 7/08**, H03K 17/74

(21) Application number: **86304902.9**

(22) Date of filing: **25.06.86**

(54) **Apparatus for increasing the switching speed of diodes.**

(30) Priority: **26.06.85 US 749156**
**26.06.85 US 749155**

(43) Date of publication of application:
**30.12.86 Bulletin 86/52**

(45) Publication of the grant of the patent:
**06.05.92 Bulletin 92/19**

(84) Designated Contracting States:
**DE FR GB**

(56) References cited:
EP-A- 0 195 500   EP-A- 0 238 748
GB-A- 1 523 879   GB-A- 2 075 294
US-A- 2 657 318   US-A- 3 239 693
US-A- 3 518 659   US-A- 3 710 140
US-A- 4 051 428   US-A- 4 518 921

IEEE Transactions on Communications, vol.
COM-28, no. 11, November 1980, pages
1849-1858; New York, US, F.M. Gardner:
"Charge-pump phase-lock loops"

(73) Proprietor: **DATA GENERAL CORPORATION**
**4400 Computer Drive**
**Westboro Massachusetts 01580(US)**

(72) Inventor: **Latham, Paul W.**
**124 Hosmer Street**
**Marlboro Massachusetts 01752(US)**

(74) Representative: **Pears, David Ashley et al**
**REDDIE & GROSE 16 Theobalds Road**
**London WC1X 8PL(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to diodes, particularly to diodes employed as on-off switches for selectively completing current paths, and more particularly to increasing the switching speeds of the diodes.

The apparatus may be used in servosystems, particularly to Type II phase-locked loops, and more particularly to charge pumps for use in Type II phase-locked loops.

References:

Charge-Pump Phase-Lock Loops, Floyd M. Gardner, IEEE Transactions on Communications, Vol.COM 28, No. 11, November 1980, p. 1849 et seq., IEEE publication number 0090-6778/80/1100-1849. (Hereinafter "Gardner").

Analysis and Design of Analog Integrated Circuits, Paul R. Gray and Robert G. Meyer, John Wiley & Sons, ISBN 0-471-01367-6. (Hereinafter, "Gray").

The prior art also includes the following United States Patents: 4,518,921; 3,339,693; 2,657,318; 3,518,659 and 3,710,140.

The present invention is defined in the independent claims to which reference should now be made.

The invention will be described by way of example with reference to the drawings, in which:-

**Figure 1** depicts a phase-locked loop of the prior art;

**Figure 2** depicts an improved phase-locked loop;

**Figure 3** is a block diagram of the charge pump of the circuit of Figure 2 incorporating apparatus for increasing the switching speed of diodes embodying the present invention; and

**Figure 4** is a timing diagram of the charge pump.

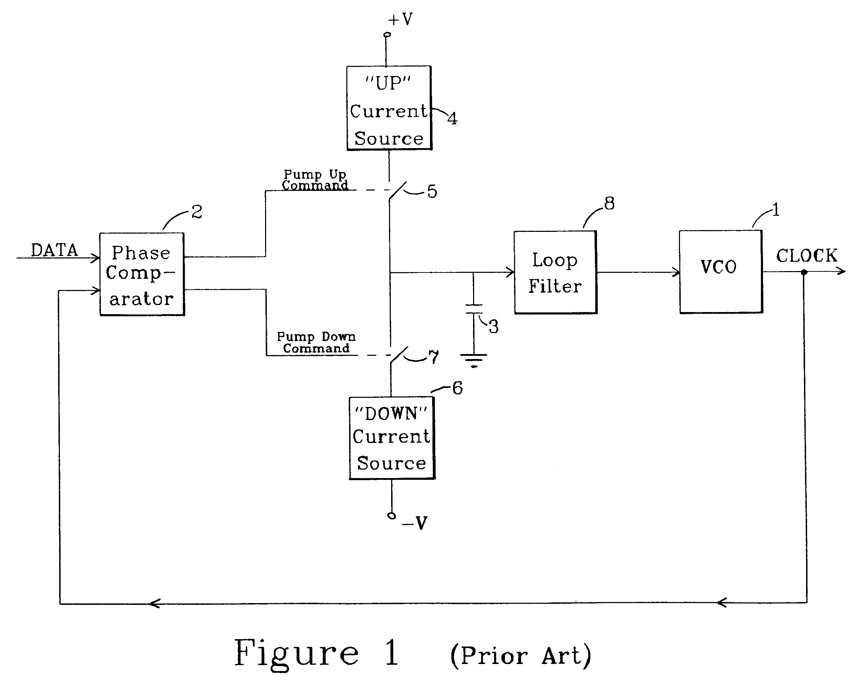

Figure 1 shows a phase-locked loop of the prior art. VCO (voltage-controlled oscillator) 1 produces a CLOCK signal which is periodic at a frequency proportional to the voltage at the input of VCO 1 (the "control voltage"). The CLOCK signal is fed back as an input to phase comparator 2, along with a DATA signal with which it is desired to synchronize the frequency and phase of the CLOCK signal. The output of phase comparator 2 consists of two non-congruent digital signals: PUMP UP and PUMP DOWN. If the DATA and CLOCK signals are synchronized, the UP and DOWN signals are of equal duration; otherwise, there will be a difference in their length proportional to the difference in phase between the DATA and CLOCK signals. The PUMP UP command causes switch 5 to close, allowing current to flow from UP current source 4 to charge integrating capacitor 3. Similarly, the PUMP DOWN command closes switch 7, allowing current to flow from DOWN current source 6, discharging capacitor 3. It is apparent that capacitor 3 integrates the two currents; since they flow in opposite directions relative to capacitor 3, the integral will be zero if the two currents were of the same duration (assuming the two currents to have the same magnitude and transient characteristics). If they were not of the same duration, the integral would be non-zero, effecting a change in the voltage to which capacitor 3 is charged. The voltage on capacitor 3, as filtered by loop filter 8, is the control voltage. (Loop filter 8 employs control theory considerations to form VCO 1's control voltage from the voltage on capacitor 3, thus providing loop stability. See Gardner.) Thus, phase differences detected by phase comparator 2 are used to alter the control voltage in a manner that alters the frequency of the CLOCK signal so as to compensate for those phase differences.

Ideally, when the DATA and CLOCK signals are perfectly synchronized, the steady-state error should be zero; i.e., the voltage across integrating capacitor 3 should not change. That is to say that the integral of the UP current should be precisely equal to minus the integral of the DOWN current. This is difficult to achieve in the prior art since, as previously discussed, there are two current sources and two separate switching paths implemented in different types of semiconductors, and so a precise match of current amplitudes and transient characteristics is precluded.

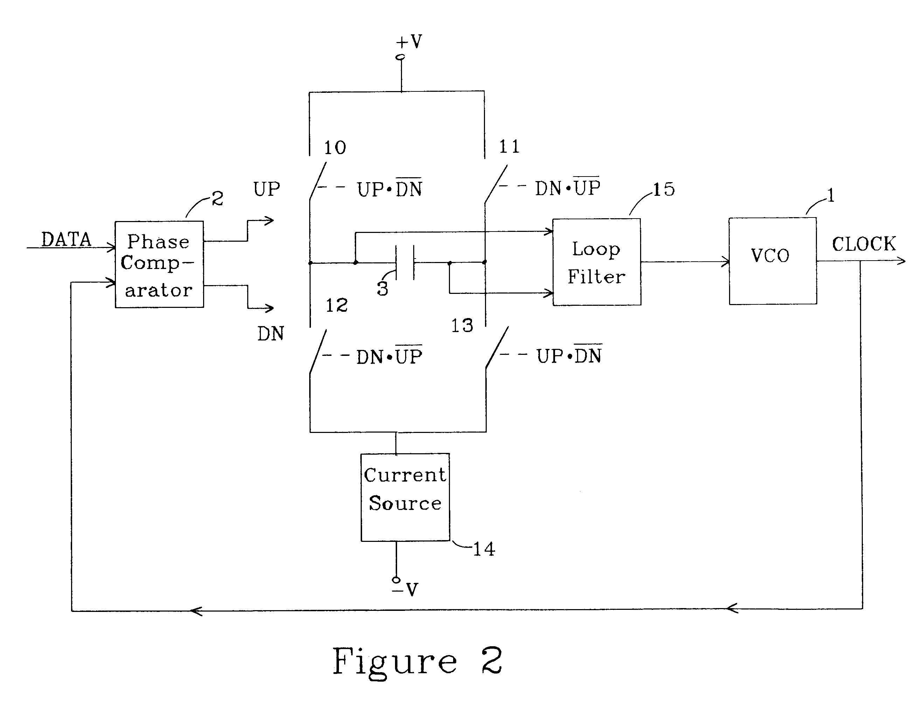

The circuitry of Figure 2 overcomes these drawbacks by providing a current pump consisting of a single current source and identical switching paths. It can be implemented using only one type of semiconductor. In Figure 2 VCO1 and phase comparator 2 may be as in the prior art. Integrating capacitor 3 is connected across a bridge, each leg of which contains a switch. The PUMP UP command causes switches 10 and 13 to close, completing a current path for current determined by current source 14 to flow in such direction as to charge capacitor 3. The PUMP DOWN command closes switches 11 and 12, completing the path for the source current to flow in such a direction as to discharge capacitor 3. Loop filter 15 is functionally equivalent to loop filter 8 of the prior art except for having differential instead of single-ended input, with integrating capacitor 3 connected across that differential input.

The difficulties of matching the characteristics of two current sources are eliminated by providing a single current source for both the PUMP UP and PUMP DOWN currents. Difficulties of matching the transient responses of differer switching paths are minimized by providing switches that all must pass current in the same direction; they can thus be identical and constructed of the same semiconductor types. Means are provided for controlling the biasing voltages on switching diodes so as to minimize their switching times.

DETAILED DESCRIPTION OF THE PREFERRED EMBODIMENT

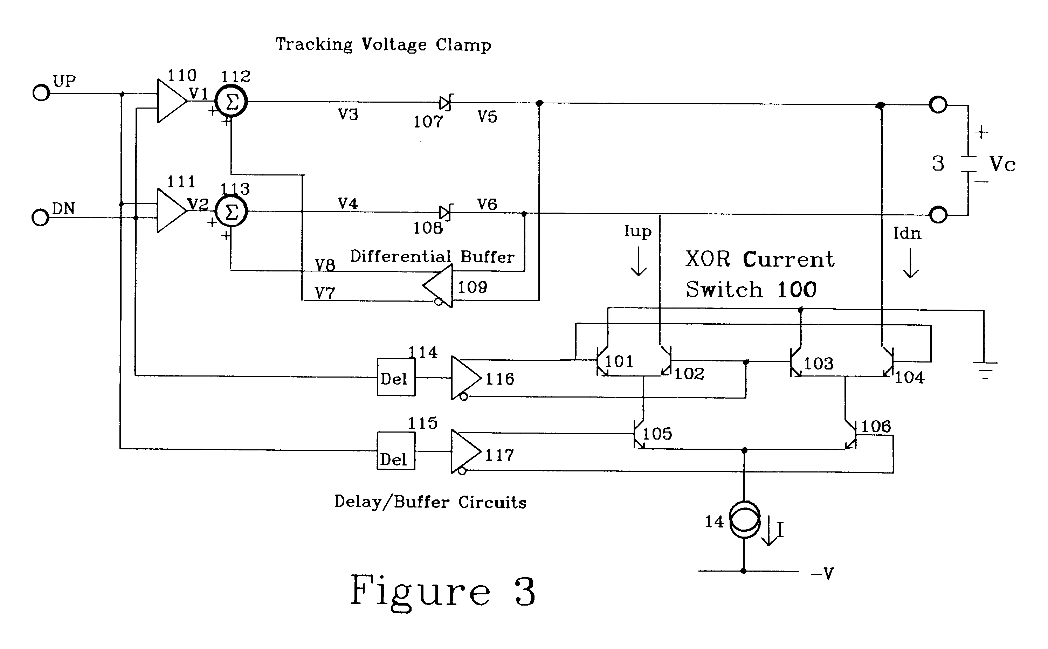

Figure 3 is a block diagram of the improved charge pump incorporating apparatus for increasing the switching speed of diodes embodying the present invention. Current source 14 and capacitor 3 both appear in Figure 3. Current switches 12 and 13 of Figure 2 are expanded in Figure 3 to exclusive-OR switch 100 comprising transistors 101 through 106. ("Up" switch 12 is expanded to transistors 102 and 105, while "down" switch 13 is expanded to transistors 104 and 106. Transistors 101 and 103 are provided to sink the source current to ground when neither up nor down current is called for, thus keeping a constant load on current source 14.) The function of voltage switches 10 and 11 of Figure 2 is performed by clamping diodes 107 and 108. Amplifiers 110 and 111, summers 112 and 113, and differential buffer 109 are provided to actuate and speed up clamping diodes 107 and 108, as will be described below. Delays 114 and 115 are provided to ensure that the exclusive-OR current switch does not respond to the UP and DN commands until clamping diodes 107 and 108 have stabilized in their responses. Buffers 116 and 117 provide signals of the proper polarity to actuate the exclusive-OR current switch.

Voltage clamp:

If capacitor 3 is to be pumped "up", the voltage source for current source 14 (switched through the exclusive-OR current switch to be described below) will be through clamping diode 107. If capacitor 3 is to be pumped "down", the voltage source will be through clamping diode 108.

To minimize the slewing time of clamping diodes 107 and 108, the voltage shifts they undergo are just sufficient to forward- or back-bias them as needed. Amplifiers 110 and 111 output V1 and V2 respectively, which can take values of either zero volts, one-half Vd (the diode junction voltage), or minus one-half Vd, depending on the states of the UP and DN inputs, as summarized in Table 1.

Differential buffer 109 keeps the same voltage difference between its two output lines as exists between its two input lines, but shifts the voltage reference so that the output lines are more positive than the input lines by an amount equal to Vd/2, where Vd is the junction voltage of diodes 107 and 108. Since the differential buffer 109 inputs are connected across capacitor 3, the voltage across which is Vc, the outputs are separated by a potential equal to Vc.

Since capacitor 3 is used differentially and does not have either of its terminals referenced to ground, the voltage across it is said to be referenced to "Vbias". (If capacitor 3, having capacitance "C", were replaced by two capacitors in series, each having capacitance 2C, Vbias would be the voltage appearing between the two capacitors.) The value of Vbias is determined within differential buffer 109; its value is not critical to the operation of the charge pump. V5, the voltage on capacitor 3's positive terminal, then has a value of Vbias + Vc/2; similarly, V6, the voltage on its negative terminal, has a value of Vbias - Vc/2. Regarding the outputs of differential buffer 109, then, V7's value is Vbias + Vc/2 + Vd/2; V8's value is Vbias - Vc/2 + Vd/2. (See Table 1.)

Summer 112 adds V1 and V7 to produce V3; summer 113 adds V2 and V8 to produce V4. (See Table 1.)

TABLE 1

| UP | DN | V1 | V2 | V3 | V4 | DIODES FORWARD-BIASED |
|----|----|----|----|----|----|----|
| 0 | 0 | 0 | 0 | V5 + Vd/2 | V6 + Vd/2 | NEITHER |
| 0 | 1 | -Vd/2 | + Vd/2 | V5 | V6 + Vd | 107 |
| 1 | 0 | + Vd/2 | -Vd/2 | V5 + Vd | V6 | 108 |
| 1 | 1 | 0 | 0 | V5 + Vd/2 | V6 + Vd/2 | NEITHER |

NOTES: Vd = diode junction voltage V5 = Vbias + Vc/2 V6 = Vbias - Vc/2 V7 = V5 + Vd/2 V8 = V6 + Vd/2

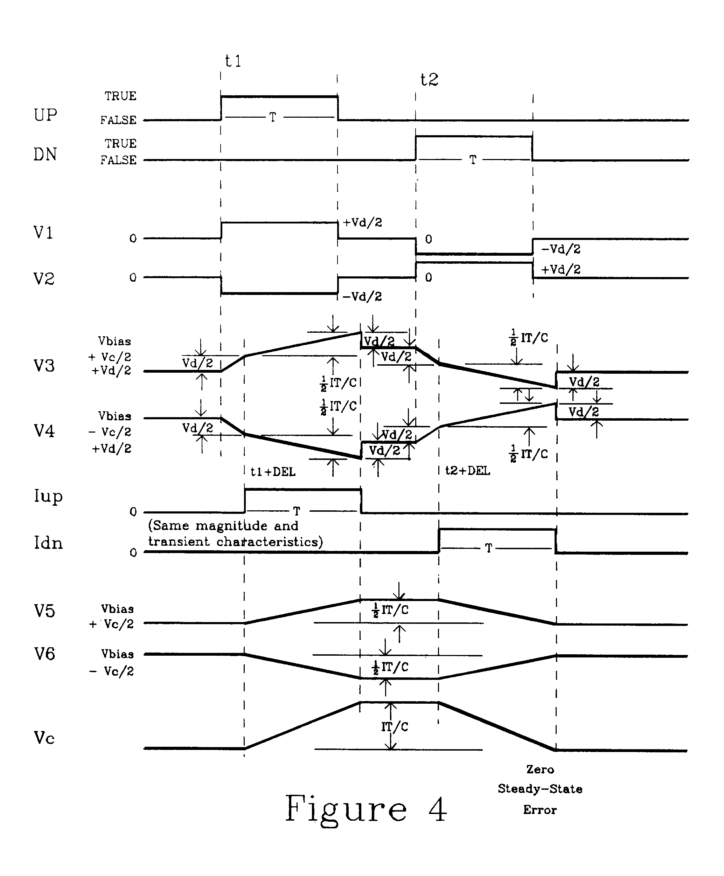

Figure 4, which depicts certain timing waveforms within the circuit, should now be consulted along with Figure 3 and Table 1. Prior to time t1, the UP and DN commands are both false, and therefore V1 and V2 both have values of zero volts. V4 is thus equal to V8, which in turn is greater by Vd/2 than V6. Diode 108's anode voltage (V4), then, is greater than its cathode voltage (V6) by half its junction voltage. This is not sufficient to forward-bias diode 108; the anode voltage must be greater than the cathode voltage by at least the full junction voltage for forward biasing to occur. By similar analysis, diode 107 is also back-biased at this time. It is thus shown that the voltage clamping switches are, in effect, open when the UP and DN commands are both false. By similar reasoning, they would also both be open if UP and DN were both true, although this condition is not permitted to occur in the present embodiment.

Referring to Figure 4, the UP command is assumed to become true at time t1. V1 then takes a value of + Vd/2. Summer 112 adds this to V3, which increases diode 107's anode voltage (V3) to a value which is greater than the cathode voltage (V6) by Vd, the junction voltage. This is sufficient to forward-bias diode 107. At the same time, V2 goes to -Vd/2. Summer 111 adds this negative value to V4, lowering diode 108's anode voltage and keeping it back-biased. The current path is thus permissive for UP current from the XOR current switch (to be discussed below) to flow through capacitor 3 in such a direction as to charge it, and to flow through diode 107. As Figure 4 shows, this charging alters the magnitudes of the voltages at the circuit points being discussed. As the voltage across capacitor 3 (and thus the cathode voltages of diodes 107 and 108) is slewed, differential buffer 109 adjusts the anode voltages commensurately, thus maintaining the aforementioned conditions of forward- and back-biasing.

Referring again to Figure 4, the UP command goes false after time T, and there is then a period where UP and DN are both false. As discussed above, this results in back-biasing both diode 107 and diode 108.

The DN command becomes true at time t2. V1 then goes to -Vd/2, and V2 goes to + Vd/2. By reasoning similar to that employed in conjunction with the UP command, it is apparent that diode 107 is back-biased and diode 108 is forward biased. This provides a current path for DN current from the XOR current switch (to be discussed below) to flow through capacitor 3 in such direction as to discharge it, and to flow through diode 108. Again, the magnitudes of the voltages at the circuit nodes being discussed slew to different values, as shown in Figure 4.

Exclusive-OR Current Switch:

Delays 114 and 115 delay the UP and DN commands to allow time for clamping diodes 107 and 108 to stabilize in the conditions described above. (Since the delay times required are quite short, about 1.5 nanoseconds, delays 114 and 115 consist simply of transistor stages, the delay time being essentially the turn-on time of the transistors.) The delayed outputs are $UP_D$ and $DN_D$ respectively, which are input to buffers 116 and 117 respectively. If the DN command is TRUE, the non-inverted output of buffer 116 turns on transistors 101 and 104, while the inverted output turns off transistors 102 and 103. The FALSE state of DN will accomplish the inverse of this.

If the UP command is TRUE, the non-inverted output of buffer 117 turns on transistor 105 while the inverted output turns off transistor 106. The FALSE state of UP will cause transistor 106 to be on and 105 to be off.

The foregoing analysis is represented in tabular form in Table 2, showing the states of transistors 101 through 106 for the four possible states of the UP and DN commands.

4

TABLE 2

| UP | DN | 101 | 102 | 103 | 104 | 105 | 106 |
|----|----|-----|-----|-----|-----|-----|-----|
| 0 | 0 | - | ON | ON | - | - | ON |
| 0 | 1 | ON | - | - | ON | - | ON |
| 1 | 0 | - | ON | ON | - | ON | - |
| 1 | 1 | ON | - | - | ON | ON | - |

Combined Operation:

In view of the foregoing analyses of the voltage clamp and the exclusive-OR current switch, it is apparent that the overall functional operation of Figure 3 is that summarized in Table 3.

TABLE 3

| UP | DN | CURRENT PATH |
|----|----|--------------|
| 0 | 0 | 14 - 106 - 103 - ground |
| 0 | 1 | 14 - 106 - 104 - 3 - 108 (discharges 3) |
| 1 | 0 | 14 - 105 - 102 - 3 - 107 (charges 3) |
| 1 | 1 | 14 - 105 - 101 - ground |

As Figure 4 shows, every occurrence of current I for duration T slews the voltage on capacitor 3 by IT/C. The foregoing discussion has assumed steady-state operation, i.e., that the CLOCK and DATA signals are synchronized and no adjustments are to be made in the frequency of CLOCK. As in the prior art, adjustments in the frequency of CLOCK could be made by allowing the UP current and the DOWN current to flow for differing amounts of time, resulting in slewing the voltage up by a different amount than that by which it is slewed down, effecting a net change in the capacitor voltage which in turn effects a change in VCO 1's control voltage.

When the UP and DN commands are both true or both false, the current through capacitor 3 should ideally be absolutely zero. In practice, that current will be the leakage current from the XOR current switch through diodes 107 or 108. The leakage current is extremely small, since it must flow through transistors 102 or 104 and then through diodes 107 or 108; transistors 102 and 104 are turned off at this time, and furthermore are shunted by transistors 101 and 103 respectively, one of which is turned on and conductive to ground at this time; diodes 107 and 108 are back-biased at this time.

It is apparent that there is but one current source, which facilitates the symmetry of the up and down currents. Since current flows in the same direction in both sides of the voltage clamping network and in both sides of the exclusive-OR current switch, all transistors can be NPN transistors.

**Claims**

1. Apparatus for increasing the switching speed of a diode (107) having an anode and a cathode, and the diode having a junction voltage which is the amount by which its anode is more positive than its cathode when the diode is in the "ON" condition, and the apparatus comprising: a first circuit (110) responsive to a first signal, the first signal specifying whether the diode is to be switched "ON" or switched "OFF", the first circuit producing at its output a first voltage of plus one-half the junction voltage when the first signal specifies "ON", and minus one-half the junction voltage when the first signal specifies "OFF"; a second circuit (109) having an input connected to the cathode for producing at its output a second voltage greater by one-half the junction voltage than the voltage appearing at the cathode; and a summer circuit (112) connected to the anode for adding the first voltage and the second voltage to produce a sum, and for applying the sum to the anode.

2. Apparatus for increasing the switching speeds of a pair of diodes (107,108), the pair of diodes consisting of a first diode (107) and a second diode (108), each having an anode and a cathode, and each diode having a junction voltage being the voltage by which its anode is more positive than its

EP 0 206 816 B1

cathode when it is in an ON state, the junction voltage of the first diode being substantially equal to the junction voltage of the second diode; the diodes being responsive to first and second voltages, the first voltage having a value of plus one-half the junction voltage when the first diode is to be turned ON and the second diode is to be turned OFF; minus one-half the junction voltage when the first diode is to be turned OFF and the second diode is to be turned ON; or zero volts when both the first and second diodes are to be turned OFF, and the second voltage having a value of plus one-half the junction voltage when the second diode is to be turned ON and the first diode is to be turned OFF; minus one-half the junction voltage when the second diode is to be turned OFF and the first diode is to be turned ON; or zero volts when both the first and second diodes are to be turned OFF, the apparatus comprising a circuit having a first input connected to the cathode of the first diode, the voltage at said cathode being a third voltage; a second input connected to the cathode of the second diode, the voltage at said cathode being a fourth voltage; a first output for producing a fifth voltage which is greater than the third voltage by one-half the junction voltage; and a second output for producing a sixth voltage which is greater than the fourth voltage by one-half the junction voltage; a first summer (112) for adding the first voltage and the fifth voltage to produce a first sum, and for applying the first sum to the anode of the first diode; and a second summer (113) for adding the second voltage and the sixth voltage to produce a second sum, and for applying the second sum to the anode of the second diode.

3. Apparatus for increasing the switching speeds of a pair of diodes, the pair of diodes consisting of a first diode (107) and a second diode (108), each having an anode and a cathode, and each diode having a junction voltage being the voltage by which its anode is more positive than its cathode when it is in an ON state, the junction voltage of the first diode being substantially equal to the junction voltage of the second diode; the apparatus being responsive to first and second signals, each being a binary signal having a true state and a false state, so as to switch the first diode ON and the second diode OFF when the first signal is true and the second signal is false; to switch the second diode ON and the first diode OFF when the second signal is true and the first signal is false; to switch both the first and second diodes OFF when the first signal and the second signal are both false; and to switch both the first and second diodes OFF when the first signal and the second signal are both true, the apparatus comprising: a first circuit (110) responsive to the first and second signals for producing a first voltage having a value of plus one-half the junction voltage when the first signal is true and the second signal false; minus one-half the junction voltage when the second signal is true and the first signal false; or zero volts when the first and second signals are both true or both false, a second circuit (111) responsive to the first and second signals for producing a second voltage having a value of plus one-half the junction voltage when the second signal is true and the first signal false; minus one-half the junction voltage when the first signal is true and second signal false; or zero volts when the first and second signals are both true or both false, a third circuit (109) having a first input connected to the cathode of the first diode, the voltage at said cathode being a third voltage; a second input connected to the cathode of the second diode, the voltage at said cathode being a fourth voltage; a first output for producing a fifth voltage which is greater than the third voltage by one-half the junction voltage; and a second output for producing a sixth voltage which is greater than the fourth voltage by one-half the junction voltage; a first summer (112) for adding the first voltage and the fifth voltage to produce a first sum, and for applying the first sum to the anode of the first diode and a second summer (113) for adding the second voltage and the sixth voltage to produce a second sum, and for applying the second sum to the anode of the second diode.

4. Apparatus according to claim 3, wherein the third circuit (109) establishes a common-mode voltage for the third and fourth voltages, the common-mode voltage being substantially constant and being substantially equal to the average of the third voltage and the fourth voltage.

**Revendications**

1. Appareil destiné à augmenter la vitesse de commutation d'une diode (107) comportant une anode et une cathode, et la diode possédant une tension de jonction qui est la valeur dont son anode est plus positive que sa cathode lorsque la diode est dans la condition "EN FONCTION" et l'appareil comprenant un premier circuit (110) sensible à un premier signal, le premier signal spécifiant si la diode doit être commutée "EN FONCTION" ou commutée "HORS FONCTION", le premier circuit produisant à sa sortie une première tension de plus une moitié de la tension de jonction lorsque le premier signal spécifie "EN FONCTION" et moins une moitié de la tension de jonction lorsque le premier signal spécifie "HORS FONCTION"; un deuxième circuit (109) comportant une entrée rèliée à la cathode pour produire à sa sortie une deuxième tension supérieure d'une moitié de la tension de jonction à la tension apparaissant à la cathode; et un circuit de sommation (112) relié à l'anode pour additionner la première et la deuxième tension pour produire une somme et pour appliquer la somme à l'anode.

2. Appareil destiné à augmenter les vitesses de commutation d'une paire de diodes (107, 108), la paire de diodes consistant en une première diode (107) et une deuxième diode (108), comportant chacune une anode et une cathode, et chaque diode possédant une tension de jonction qui est la tension dont son anode est plus positive que sa cathode lorsqu'elle est dans un état EN FONCTION, la tension de jonction de la première diode étant sensiblement égale à la tension de jonction de la deuxième diode; les diodes étant sensibles à une première et une deuxième tension, la première tension étant d'une valeur de plus une moitié de la tension de jonction lorsque la première diode doit être mise EN FONCTION et que la deuxième diode doit être mise HORS FONCTION; moins une moitié de la tension de jonction lorsque la première diode doit être mise HORS FONCTION et que la deuxième diode doit être mise EN FONCTION; ou zéro volt lorsque la première et la deuxième diodes doivent toutes deux être mises HORS FONCTION, et la deuxième tension présentant une valeur de plus une moitié de la tension de jonction lorsque la deuxième diode doit être mise EN FONCTION et que la première diode doit être mise HORS FONCTION; moins une moitié de la tension de jonction lorsque la deuxième diode doit être mise HORS FONCTION et que la première diode doit être mise EN FONCTION; ou zéro volt lorsque la première et la deuxième diodes doivent toutes deux être mises HORS FONCTION, l'appareil comprenant un circuit comportant une première entrée reliée à la cathode de la première diode, la tension à ladite cathode étant une troisième tension; une deuxième entrée reliée à la cathode de la deuxième diode, la tension à ladite cathode étant une quatrième tension; une première sortie pour produire une cinquième tension qui est supérieure d'une moitié de la tension de jonction à la troisième tension ; et une deuxième sortie destinée à produire une sixième tension qui est supérieure d'une moitié de la tension de jonction à la quatrième tension; et un premier additionneur (112) pour ajouter la première tension et la cinquième tension pour produire une première somme et pour appliquer la première somme à l'anode de la première diode; et un deuxième additionneur (113) pour additionner la deuxième tension et la sixième tension pour produire une deuxième somme et pour appliquer la deuxième somme à l'anode de la deuxième diode.

3. Appareil destiné à augmenter les vitesses de commutation d'une paire de diodes, la paire de diodes consistant en une première diode (107) et une deuxième diode (108), comportant chacune une anode et une cathode, et chaque diode possédant une tension de jonction qui est la tension dont son anode est plus positive que sa cathode lorsqu'elle est dans un état EN FONCTION, la tension de jonction de la première diode étant sensiblement égale à la tension de jonction de la deuxième diode; l'appareil étant sensible à un premier et un deuxième signaux, qui sont chacun un signal binaire comportant un état vrai et un état faux, de manière à commuter la première diode EN FONCTION et la deuxième diode HORS FONCTION lorsque le premier signal est vrai et que le deuxième signal est faux; à commuter la deuxième diode EN FONCTION et la deuxième diode HORS FONCTION lorsque le deuxième signal est vrai et que le premier signal est faux; à commuter la première et la deuxième diodes toutes deux HORS FONCTION lorsque le premier signal et le deuxième signal sont tous deux faux; et à commuter la première et la deuxième diodes toutes deux HORS FONCTION lorsque le premier signal et le deuxième signal sont tous vrais, l'apppareil comprenant : un premier circuit (110) sensible au premieret au deuxième signaux pour produire une première tension comportant une valeur de plus une moitié de la tension de jonction lorsque le premier signal est vrai et que le deuxième signal est faux; moins une moitié de la tension de jonction lorsque le deuxième signal est vrai et que le premier signal est faux; ou zéro volt lorsque le premier et le deuxième signaux sont tous deux vrais ou tous deux faux, un deuxième circuit (111) sensible au premier et au deuxième signaux pour produire une deuxième tension dont la valeur est plus une moitié de la tension de jonction lorsque le deuxième signal est vrai et que le premier signal est faux; moins une moitié de la tension de jonction lorsque le premier signal est vrai et que le deuxième signal est faux; ou zéro volt lorsque le premier et le deuxième signaux sont tous deux vrais ou tous deux faux, un troisième circuit (109) comportant une première entrée reliée à la cathode de la première diode, la tension à ladite cathode étant une troisième tension; une deuxième entrée reliée à la cathode de la deuxième diode, la tension à ladite cathode étant une quatrième tension; une première sortie destinée à produire une cinquième tension

7

qui est supérieure d'une moitié de la tension de jonction à la troisième tension; et une deuxième sortie destinée à produire une sixième tension qui est supérieure d'une moitié de la tension de jonction à la quatrième tension; un premier additionneur (112) pour additionner la première tension et la cinquième tension pour produire une première somme et pour appliquer la première somme à l'anode de la première diode et un deuxième additionneur (113) pour additionner la deuxième tension et la sixième tension pour produire une deuxième somme et appliquer la deuxième somme à l'anode de la deuxième diode.

4. Appareil selon la revendication 3, dans lequel le troisième circuit (109) établit une tension de mode commun pour la troisième et la quatrième tensions, la tension de mode commun étant sensiblement constante et étant sensiblement égale à la moyenne de la troisième tension et de la quatrième tension.

**Patentansprüche**

1. Vorrichtung zur Beschleunigung der Schaltgeschwindigkeit einer Diode (107) mit einer Anode, einer Katode und einer Sperrschichtspannung, die der Betrag ist,um welchen ihre Anode positiver als ihre Katode ist, wenn sie sich im Zustand "EIN" befindet, enthaltend: einen ersten Schaltkreis (110), der auf ein erstes Signal anspricht, das angibt, ob die Diode ein- oder ausgeschaltet werden soll, wobei der erste Schaltkreis an seinem Ausgang eine erste Spannung abgibt, die plus der halben Sperrspannung ist, wenn das erste Signal "EIN" angibt, bzw. minus der halben Sperrspannung ist, wenn das erste Signal "AUS" angibt; einen zweiten Schaltkreis (109) mit einem mit der Katode verbundenen Eingang zwecks Abgabe einer zweiten Spannung, die um die halbe Sperrschichtspannung größer als die an der Katode erscheinende Spannung ist, an seinem Ausgang; und eine mit der Anode verbundene Summierschaltung (112) zur Addition der ersten Spannung und der zweiten Spannung unter Erzeugung einer Summe und zum Anlegen dieser Summe an die Anode.

2. Vorrichtung zur Beschleunigung der Schaltgeschwindigkeiten eines Paars von Dioden (107,108), das aus einer ersten Diode (107) und einer zweiten Diode (108) besteht, die jeweils eine Anode, eine Katode und eine Sperrschichtspannung aufweisen, welche diejenige Spannung ist, um welche die Anode jeweils positiver als die Katode ist, wenn sich die betreffende Diode im "EIN"-Zustand befindet, wobei die Sperrschichtspannung der ersten Diode im wesentlichen gleich der Sperrschichtspannung der zweiten Diode ist und wobei die Dioden auf erste und zweite Spannung ansprechen, von denen die erste Spannung einen Wert besitzt, der plus der halben Sperrschichtspannung ist, wenn die erste Diode eingeschaltet und die zweite Diode ausgeschaltet werden soll, minus der halben Sperrschichtspannung ist, wenn die erste Diode ausgeschaltet und die zweite Diode eingeschaltet werden soll, oder Null Volt beträgt, wenn sowohl die erste als auch die zweite Diode ausgeschaltet werden soll, von denen die zweite Spannung einen Wert besitzt, der plus der halben Sperrschichtspannung ist, wenn die zweite Diode eingeschaltet und die erste Diode ausgeschaltet werden soll, minus der halben Sperrschichtspannung ist, wenn die zweite Diode ausgeschaltet und die erste Diode eingeschaltet werden soll, oder Null Volt beträgt, wenn sowohl die erste als auch die zweite Diode ausgeschaltet werden soll, enthaltend: einen Schaltkreis mit einem ersten, mit der Katode der ersten Diode verbundenen Eingang, wobei die Spannung an dieser Katode eine dritte Spannung ist, einem zweiten, mit der Katode der zweiten Diode verbundenen Eingang, wobei die Spannung an dieser Katode eine vierte Spannung ist, einem ersten Ausgang zur Erzeugung einer fünften Spannung, die um die Hälfte der Sperrschichtspannung größer als die dritte Spannung ist, und einem zweiten Ausgang zur Erzeugung einer sechsten Spannung, die um die Hälfte der Sperrschichtspannung größer als die vierte Spannung ist; eine erste Summierschaltung (112) zum Addieren der ersten Spannung und der fünften Spannung unter Erzeugung einer ersten Summe und zum Anlegen dieser ersten Summe an die Anode der ersten Diode; und eine zweite Summierschaltung (113) zum Addieren der zweiten Spannung und der sechsten Spannung unter Erzeugung einer zweiten Summe und zum Anlegen der zweiten Summe an die Anode der zweiten Diode.

3. Vorrichtung zur Beschleunigung der Schaltgeschwindigkeiten eines Paars von Dioden, wobei das Paar eine erste Diode (107) und eine zweite Diode (108) enthält, von denen jede eine Anode, eine Katode und eine Sperrschichtspannung aufweist, welche diejenige Spannung ist, um welche die Anode jeweils positiver als die Katode ist, wenn sich die jeweilige Diode im "EIN"-Zustand befindet, wobei die Sperrschichtspannung der ersten Diode im wesentlichen gleich der Sperrschichtspannung der zweiten Diode ist, und wobei die Vorrichtung auf erste und zweite Signale anspricht, die beide Binärsignale mit einem richtigen Zustand und einem falschen Zustand sind, um die erste Diode ein- und die zweite Diode auszuschalten, wenn das erste Signal richtig und das zweite Signal falsch ist, um die zweite Diode ein- und die erste Diode auszuschalten, wenn das zweite Signal richtig und das erste Signal falsch ist, um beide Dioden auszuschalten, wenn das erste Signal und das zweite Signal beide falsch sind, und beide Dioden auszuschalten, wenn das erste Signal und das zweite Signal beide richtig sind, enthaltend: einen ersten Schaltkreis (110), der auf die ersten und zweiten Signale unter Erzeugung einer ersten Spannung anspricht, die einen Wert von plus der halben Sperrschichtspannung besitzt, wenn das erste Signal richtig und das zweite Signal falsch ist, minus der halben Sperrschichtspannung ist, wenn das zweite Signal richtig und das erste Signalfalsch ist, oder Null Volt beträgt, wenn die ersten und zweiten Signale beide richtig oder beide falsch sind; einen zweiten Schaltkreis (111), der auf die ersten und zweiten Signale unter Erzeugung einer zweiten Spannung anspricht, die einen Wert besitzt, der plus der halben Sperrschichtspannung ist, wenn das zweite Signal richtig und das erste Signal falsch ist, minus der halben Sperrschichtspannung ist, wenn das erste Signal richtig und das zweite Signal falsch ist, oder Null Volt beträgt, wenn die ersten und zweiten Signale beide richtig oder beide falsch sind; einen dritten Schaltkreis (109) mit einem ersten, mit der Katode der ersten Diode verbundenen Eingang, wobei die Spannung an dieser Katode eine dritte Spannung ist, einem zweiten, mit der Katode der zweiten Diode verbundenen Eingang, wobei die Spannung an dieser Katode eine vierte Spannung ist, einem ersten Ausgang zur Erzeugung einer fünften Spannung, die um die Hälfte der Sperrschichtspannung größer als die dritte Spannung ist, und einem zweiten Ausgang zur Erzeugung einer sechsten Spannung, die um die Hälfte der Sperrschichtspannung größer als die vierte Spannung ist; eine erste Summierschaltung (112) zum Addieren der ersten Spannung und der fünften Spannung unter Erzeugung einer ersten Summe und zum Anlegen dieser ersten Summe an die Anode der ersten Diode; und eine zweite Summierschaltung (113) zum Addieren der zweiten Spannung und der sechsten Spannung unter Erzeugung einer zweiten Summe und zum Anlegen der zweiten Summe an die Anode der zweiten Diode.

4. Vorrichtung nach Anspruch 3, wobei der dritte Schaltkreis (109) jeweils eine Gleichtaktspannung für die dritten und vierten Spannungen liefert, wobei die Gleichtaktspannung im wesentlichen konstant und im wesentlichen gleich dem Durchschnitt der dritten Spannung und der vierten Spannung ist.

Figure 1 (Prior Art)

Figure 2

Figure 3

EP 0 206 816 B1

Figure 4